# EUROPÄISCHE PATENTSCHRIFT

(11) **EP 1 135 857 B1**
(45) Veröffentlichungstag und Bekanntmachung des Hinweises auf die Patenterteilung: **28.07.2010**
(21) Anmeldenummer: 99969188.4
(22) Anmeldetag: 07.09.1999
(51) Int. Cl.: H03K 17/082

(54) **SCHUTZVERFAHREN FÜR EIN STEUERBARES NICHT EINRASTENDES HALBLEITER-SCHALTELEMENT UND HIERZU KORRESPONDIERENDE SCHUTZSCHALTUNG**
METHOD FOR PROTECTING A CONTROLLABLE, NON-LOCKING SEMICONDUCTOR SWITCHING ELEMENT AND CORRESPONDING PROTECTIVE CIRCUIT
PROCEDE POUR PROTEGER UN ELEMENT DE COMMUTATION A SEMICONDUCTEUR, SANS VERROUILLAGE ET POUVANT ETRE COMMANDE, ET CIRCUIT DE PROTECTION CORRESPONDANT

(30) Priorität: 14.09.1998 DE 19842045
(43) Veröffentlichungstag der Anmeldung: 26.09.2001
(73) Patentinhaber: SIEMENS AKTIENGESELLSCHAFT, 80333 München (DE)
(72) Erfinder: SOMMER, Rainer, D-91336 Heroldsbach (DE); ZAISER, Georg, D-91058 Erlangen (DE)
(86) Internationale Anmeldenummer: PCT/DE1999/002830
(87) Internationale Veröffentlichungsnummer: WO 2000/016481

(56) Entgegenhaltungen:
- EP-A- 0 467 682
- EP-A- 0 703 664
- RUEEDI H: "INTELLIGENT INTERFACES BETWEEN POWER AND CONTROL: GATE DRIVERS FOR IGBTS" COMPONENTS,DE,SIEMENS AKTIENGESELLSCHAFT. MUNCHEN, Bd. 31, Nr. 3, 1. Mai 1996 (1996-05-01), Seiten 8-11, XP000623754 ISSN: 0945-1137

## Beschreibung

Die vorliegende Erfindung betrifft ein Schutzverfahren für ein steuerbares, nicht einrastendes Halbleiter-Schaltelement mit zwei Schaltanschlüssen und einem Steueranschluß, wobei eine zwischen den Schaltanschlüssen liegende Verbindungsstrecke durch Ansteuern des Steueranschlusses niederohmig bzw. hochohmig gesteuert wird, sowie eine hiermit korrespondierende Schutzschaltung. Beispiele derartiger Halbleiter-Schaltelemente sind MOSFETs, IGBTs oder Bipolar-Transistoren.

Derartige Halbleiter-Schaltelemente sind prinzipiell kurzschlußfest. Mit anderen Worten: Sie begrenzen einen möglicherweise auftretenden Kurzschlußstrom auf Werte von typischerweise dem fünf- bis zehnfachen ihres Nennstroms. Der Betrieb im Kurzschluß ist in der Regel aber nur für eine kurze Zeitspanne von z. B. 10 µs zulässig. Um eine Zerstörung des Halbleiter-Schaltelements im Falle eines Kurzschlusses zu vermeiden, muß daher im Falle eines Kurzschlusses die Verbindungsstrecke hochohmig gesteuert werden. Hierfür ist eine schnelle Erfassung des Kurzschlusses unbedingt erforderlich.

An eine Kurzschlußerfassung sind folgende Forderungen zu stellen:
- Kurzschlußströme und Überströme im Halbleiter-Schaltelement müssen schnell und sicher erkannt werden.
- Die Kurzschlußerkennung muß in allen Betriebsbereichen, insbesondere auch bei Schwingungen während der Entsättigung des Halbleiter-Schaltelements, störunempfindlich sein.
- Während betriebsmäßiger schaltvorgänge, insbesondere während des Einschaltvorgangs, darf kein ungewolltes Auslösen einer Überstromabschaltung erfolgen.

Zum Schutz des Halbleiter-Schaltelements sind mehrere Schutzverfahren bekannt.

So ist beispielsweise bekannt, über Stromsensoren innerhalb des Halbleiter-Schaltelements direkt den durch das Halbleiter-Schaltelement fließenden Strom zu messen. Nachteilig hierbei ist, daß ein zusätzlicher Stromsensor innerhalb des Halbleiter-Schaltelements erforderlich ist. Darüber hinaus ist eine Berücksichtigung des Temperaturverhaltens des Halbleiter-Schaltelements bei dieser Lösung nur mit großem Aufwand möglich.

Es ist ferner bekannt, über Auskoppeldioden eine über den Schaltanschlüssen abfallende Schaltelementspannung zu erfassen und mit einem Spannungsgrenzwert zu vergleichen. Eine Abschaltung des Halbleiter-Schaltelements folgt bei Überschreiten des Spannungsgrenzwerts. Auch bei diesem Verfahren kann aber eine Temperaturabhängigkeit der Schaltelementspannung nicht oder nur mit großem Aufwand berücksichtigt werden.

Darüber hinaus tritt für einen gewissen Zeitraum beim Einschalten des Halbleiter-Schaltelements eine höhere Schaltelementspannung auf (dynamische Sättigung). Es ist zwar möglich, während des Einschaltvorgangs die Überstromerfassung zu sperren. Insbesondere bei langsam schaltenden Hochvolt-Schaltelementen (Sperrspannungen über 3 kV) liegt die erforderliche Ausblendzeit aber über der zulässigen Kurzschlußzeit. Daher ergibt sich in diesem Fall, daß entweder ein sicherer Betrieb des Halbleiter-Schaltelements nicht mehr vollständig möglich ist oder der maximal einschaltbare Strom beschränkt werden muß.

Schließlich ist es auch noch bekannt, den Spannungsgrenzwert entsprechend dem Einschaltverhalten des Halbleiter-Schaltelements nachzuführen. Dies ist aber sehr aufwendig. Darüber hinaus ist eine Anpassung an das jeweilige Halbleiter-Schaltelement erforderlich. Auch ist eine Temperaturabhängigkeit des Einschaltverhaltens nur schwer berücksichtigbar.

Aus der EP 0 703 664 A2 ist ein Schutzverfahren für ein steuerbares, nicht einrastendes Halbleiter-Schaltelement mit zwei Schaltanschlüssen und einem Steueranschluss bekannt, bei dem eine Geschwindigkeit erfasst wird, mit der eine über den Schaltanschlüssen abfallende Schaltelementspannung sich ändert. Wenn ein zur Geschwindigkeit proportionales Anstiegssignal einen Spannungsgrenzwert überschreitet, wird eine zwischen den Schaltanschlüssen liegende Verbindungsstrecke durch Ansteuern des Steueranschlusses hochohmig gesteuert. Die EP 0 703 664 A2 offenbart weiterhin eine Schutzschaltung, mit der ein derartiges Schutzverfahren realisiert wird.

Die Aufgabe der vorliegenden Erfindung besteht darin, ein Schutzverfahren und eine hiermit korrespondierende Schutzschaltung zur Verfügung zu stellen, mittels derer auf einfache und zuverlässige Weise ein sicherer Betrieb des Halbleiter-Schaltelements möglich ist.

Die Aufgabe wird durch ein Schutzverfahren mit den Merkmalen des Anspruchs 1 sowie durch eine Schutzschaltung mit den Merkmalen des Anspruchs 9 gelöst. Vorteilhafte Ausgestaltungen sind Gegenstand der unabhängigen Ansprüche 2 bis 8 und 10 bis 17.

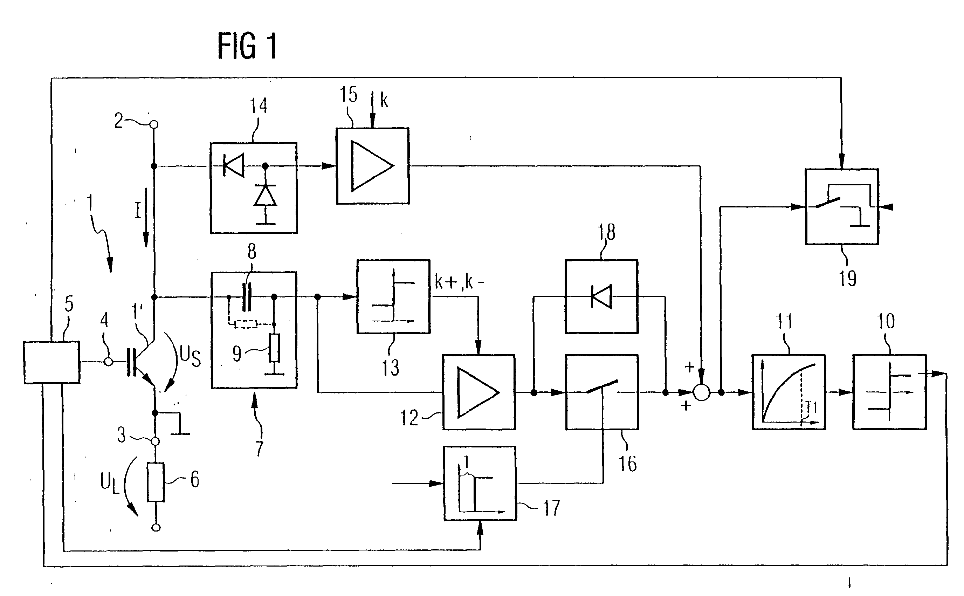

Weitere Vorteile und Einzelheiten ergeben sich aus der nachfolgenden Beschreibung eines Ausführungsbeispiels. Dabei zeigt in Prinzipdarstellung die einzige
- Fig. 1: ein Halbleiter-Schaltelement mit einer Schutzschal- tung.

Gemäß Fig. 1 weist ein steuerbares, nicht einrastendes Halbleiter-Schaltelement 1 zwei Schaltanschlüsse 2, 3 und einen Steueranschluss 4 auf. Das Halbleiter-Schaltelement 1 ist gemäß Fig. 1 als IGBT ausgebildet. Es könnte aber auch als MOSFET oder als Bipolar-Transistor ausgebildet sein. Der Steueranschluss 4 ist von einem Ansteuerelement 5 ansteuerbar. Je nach Ansteuerung durch das Ansteuerelement 5 wird eine zwischen den Schaltanschlüssen 2, 3 liegende Verbindungsstrecke 1' niederohmig bzw. hochohmig gesteuert.

Wenn die Verbindungsstrecke 1' durch entsprechendes Ansteuern des Steueranschlusses 4 niederohmig gesteuert ist, fließt ein Strom I durch eine Last 6. Der Strom I wird durch den ohmschen Widerstand der Last 6 begrenzt. Zwischen den Schaltanschlüssen 2, 3 fällt dabei eine Schaltelementspannung Uₛ ab.

Wenn aber in der Last 6 ein Kurzschluß auftritt, bricht der ohmsche Widerstand der Last 6 zusammen. Eine über der Last 6 abfallende Lastspannung U_{L} bricht daher ebenfalls zusammen. Der Strom I steigt mit einer Steilheit an, die durch eine wirksame Induktivität der Last 6 bestimmt ist, bis das Halbleiter-Schaltelement 1 Spannung aufnimmt (Entsättigung) und den Strom I begrenzt. Ohne weitere Maßnahmen, insbesondere das Abschalten des Halbleiter-Schaltelements 1, würde dieses aber durch den Strom I binnen kurzer Zeit zerstört werden.

Um eine Zerstörung des Halbleiter-Schaltelements 1 zu verhindern, ist eine Spannungsanstiegserkennungsschaltung 7 mit den Schaltanschlüssen 2, 3 verbunden. Die Spannungsanstiegserkennungsschaltung besteht im einfachsten Fall aus einem Kondensator 8 und einem Widerstand 9. Mittels der Spannungsanstiegserkennungsschaltung 7 wird ein Anstieg der Schaltelementspannung Uₛ erfaßt. Die Spannungsanstiegserkennungsschaltung 7 ist über eine Verbindungsleitung mit einem Trennsignalgeber 10 verbunden. Der Trennsignalgeber 10 ist - gemäß Ausführungsbeispiel über das Ansteuerelement 5 - mit dem Steueranschluß 4 verbunden. Der Trennsignalgeber 10 gibt ein Trennsignal für das Halbleiter-Schaltelement 1 an den Steuerabschluß 4 aus, wenn der Anstieg einen Anstiegsgrenzwert überschreitet. Die Verbindungsstrecke 1' wird in diesem Fall also hochohmig gesteuert, das Halbleiter-Schaltelement 1 abgeschaltet.

Um zu verhindern, daß kurzzeitige transiente Störungen wie sie insbesondere beim Schalten des Halbleiter-Schaltelements 1 oder bei Lastwechseln auftreten, zu einem versehentlichen Abschalten des Halbleiter-Schaltelements 1 führen, ist dem Trennungssignalgeber 10 ein Glättungselement 11 vorgeordnet. Mittels des Glättungselements 11 wird der Anstieg geglättet. Das Glättungselement 11 ist gemäß Ausführungsbeispiel als PT1-Glied ausgebildet. Es weist eine maximale Ansprechzeit T1 von 10 bis 20 µs auf.

Der Spannungsanstiegserkennungsschaltung 7 ist ein Anstiegsverstärker 12 nachgeordnet. Diesem ist ein Vorzeichenerkenner 13 zugeordnet. Der Vorzeichenerkenner 13 ist mit dem Anstiegsverstärker 12 verbunden. Mittels des Vorzeichenerkenners 13 ist dem Anstiegsverstärker 12 je nachdem, ob der Anstieg größer oder kleiner Null ist (die Schaltelementspannung Uₛ also steigt oder sinkt), ein großer Anstiegsverstärkungsfaktor k+ oder ein kleiner Anstiegsverstärkungsfaktor k- vorgebbar. Der Anstieg wird von dem Anstiegsverstärker 12 also gewichtet, wobei das Wichten des Anstiegs vorzeichenspezifisch erfolgt. Der bei einem Anstieg über Null vorgegebene Anstiegsverstärkungsfaktor k+ ist dabei größer als der bei einem Anstieg unter Null vorgegebene Anstiegsverstärkungsfaktor k-. Typischerweise liegt das Verhältnis der Anstiegsverstärkungsfaktoren k+, k- zwischen 5 und 10. Aufgrund des stärkeren Wichtens eines Anstiegs (im Gegensatz zu einem Abfall) wird im Ergebnis erreicht, daß bei einem Anstieg das Glättungselement 11 mit einer wirksamen Ansprechzeit T1 reagiert, die deutlich unter 10 µs liegt.

Um einen Kurzschluß auch bei einem sehr langsamen Ansteigen der Schaltelementspannung Uₛ, wie es beispielsweise bei einer angeschlossenen Induktivität auftreten könnte, rechtzeitig zu erfassen, ist mit den Schaltanschlüssen 2, 3 eine Spannungserkennungsschaltung 14 verbunden. Mittels der Spannungserkennungsschaltung 14 wird die Schaltelementspannung Uₛ erfaßt und überwacht. Die Spannungserkennungsschaltung 14 ist mit der Verbindungsleitung verbunden. Somit wird das Halbleiter-schaltelement 1 auch dann abgeschaltet, wenn die Schaltelementspannung Uₛ bzw. ein mit ihr korrespondierendes Meßsignal einen Spannungsgrenzwert überschreitet.

Gemäß Ausführungsbeispiel ist die Spannungserkennungsschaltung 14 als von der Spannungsanstiegserkennungsschaltung 7 getrennte Schaltung realisiert, die hinter dem Anstiegsverstärker 12 mit der Verbindungsleitung verbunden ist. Zwischen der Spannungserkennungsschaltung 14 und der Verbinäungsleitung ist dabei ein Spannungsverstärker 15 angeordnet. Der Anstieg und das Meßsignal werden also erst nach dem verstärken des Anstiegs addiert. Aufgrund des Spannungsverstärkers 15 ist es dabei möglich, das Meßsignal vor dem Addieren mit einem eigenen Spannungsverstärkungsfaktor k zu wichten.

Alternativ könnte eine Spannungserkennungsschaltung aber beispielsweise auch in die Spannungsanstiegserkennungsschaltung 7 mit integriert werden. In diesem Fall wäre die Spannungserkennungsschaltung vor dem Anstiegsverstärker 12 mit der Verbindungsleitung verbunden. Der Anstieg und das Meßsignal würden in diesem Fall selbstverständlich vor dem Verstärken des Anstiegs addiert werden. Eine einfache Möglichkeit zur Realisierung einer derartigen Spannungserkennungsschaltung bestünde beispielsweise darin, dem Kondensator 8 einen Widerstand parallelzuschalten. Ein derartiger Widerstand ist in Fig. gestrichelt eingezeichnet.

Beim Niederohmigsteuern der Verbindungsstrecke 1' kann - z.B. aufgrund parasitärer Effekte - während einer kurzen Zeitspanne nach Beginn eines Einschaltvorgangs ein relativ großer Spannungsanstieg erfolgen, der dennoch nicht auf einen Kurzschluß zurückzuführen ist. Ein derartiger Anstieg muß von der Schutzschaltung toleriert werden. Zwischen der Spannungsanstiegserkennungsschaltung 7 und dem Trennsignalgeber 10 ist daher ein Schalter 16 angeordnet. Der Schalter 16 ist mit dem Ansteuerelement 5 über einen Impulsgeber 17 verbunden.

Beim Ansteuern des Steueranschlusses 4 gibt das Ansteuerelement 5 gleichzeitig ein Startsignal an den Impulsgeber 17 aus. Dieser steuert daher während einer Ausblendzeit T den Schalter 16 an, so daß dieser während der Ausblendzeit T geöffnet wird, wenn das Ansteuerelement 5 ein Verbindungssignal an den Steueranschluß 4 ausgibt. Hierdurch ist die Spannungsanstiegserkennungsschaltung 7 von dem Trennsignalgeber 10 abgekoppelt. Sie wird erst nach der Ausblendzeit T wieder mit dem Trennsignalgeber 10 verbunden. Ein während der Ausblendzeit T nach dem Verbinden der Schaltanschlüsse 2, 3 auftretender Anstieg bleibt daher ohne Auswirkung auf das Schaltverhalten des Halbleiter-Schaltelements 1. Ein Abschalten des Halbleiter-Schaltelements 1 erfolgt nur dann, wenn der Anstieg den Anstiegsgrenzwert auch nach der Ausblendzeit T noch überschreitet. Die Ausblendzeit T ist erheblich kleiner als die Ansprechzeit T1 des Glättungselements 11. Sie liegt typisch im Bereich zwischen 1 und 5 µs, z. B. bei 2 µs.

Wenn große Ströme I geschaltet werden sollen, muß das Halbleiter-Schaltelement 1 langsam eingeschaltet werden. Dadurch sinkt die Schaltelementspannung Uₛ nur langsam ab. Allein die Spannungserkennungsschaltung 14 würde in einem solchen Fall eine unzulässige Überspannung melden, welche über das Glättungselement 11 und den Trennsignalgeber 10 ein Abschalten des Halbleiter-Schaltelements 1 auslösen würde. Andererseits sinkt während des Niederohmigsteuerns der Verbindungsstrecke 1' die Schaltelementspannung Uₛ kontinuierlich ab. Um ein ungewolltes Abschalten des Halbleiter-Schaltelements 1 aufgrund einer scheinbar überhöhten Schaltelementspannung Uₛ zu verhindern, ist dem Schalter 16 daher eine Diode 18 parallel gegengeschaltet. Hierdurch wird bei einem Absinken der Schaltelementspannung Uₛ, also bei einem Absinken des Anstiegs unter Null, der Anstieg (der kleiner als Null ist) auf die Schaltelementspannung Uₛ aufaddiert. Somit erfolgt im Ergebnis ein Anheben des Spannungsgrenzwertes. Es erfolgt also eine Selbstanpassung der Schutzschaltung an das aktuelle Schaltverhalten des Halbleiter-Schaltelements 1.

Abschließend sei noch erwähnt, daß die Schutzschaltung eine Rücksetzsteuerung 19 aufweist. Diese ist erforderlich, um eine Selbstblockierung der Schutzschaltung zu verhindern, wenn die Verbindungsstrecke 1' hochohmig gesteuert ist. Die Rücksetzsteuerung 19 wird ebenfalls vom Ansteuerelement 5 angesteuert.

## Patentansprüche

1. Schutzverfahren für ein steuerbares, nicht einrastendes Halbleiter-Schaltelement (1) mit zwei Schaltanschlüssen (2, 3) und einem Steueranschluss (4),
- wobei eine Geschwindigkeit erfasst wird, mit der eine über den Schaltanschlüssen (2, 3) abfallende Schaltelementspannung (Uₛ) sich ändert,
- wobei auch die Schaltelementspannung (Uₛ) erfasst wird,
- wobei ein zur Geschwindigkeit proportionales Anstiegssignal und ein zur Schaltelementspannung (Uₛ) proportionales Messsignal zu einem Summensignal addiert werden,
- wobei eine zwischen den Schaltanschlüssen (2, 3) liegende Verbindungsstrecke (1') durch Ansteuern des Steueranschlusses (4) hochohmig gesteuert wird, wenn das Summensignal einen Spannungsgrenzwert überschreitet.

2. Schutzverfahren nach Anspruch 1,
**dadurch gekennzeichnet,**
**dass** das Summensignal geglättet wird.

3. Schutzverfahren nach Anspruch 1 oder 2,
**dadurch gekennzeichnet,**
**dass** das Anstiegssignal mit einem Anstiegsverstärkungsfaktor (k+, k-) gewichtet wird.

4. Schutzverfahren nach Anspruch 3,
**dadurch gekennzeichnet,**
**dass** das Wichten des Anstiegssignals vorzeichenspezifisch erfolgt.

5. Schutzverfahren nach Anspruch 3 oder 4,
**dadurch gekennzeichnet,**
**dass** das Anstiegssignal und das Messsignal vor dem Verstärken des Anstiegssignals addiert werden.

6. Schutzverfahren nach Anspruch 3 oder 4,
**dadurch gekennzeichnet,**
**dass** das Anstiegssignal und das Messsignal nach dem Verstärken des Anstiegssignals addiert werden.

7. Schutzverfahren nach einem der obigen Ansprüche,
**dadurch gekennzeichnet,**
**dass** das Messsignal vor dem Addieren mit einem Spannungsverstärkungsfaktor (k) gewichtet wird.

8. Schutzverfahren nach einem der obigen Ansprüche,
**dadurch gekennzeichnet,**
**dass** während einer Ausblendzeit (T) nach einem Einschalten des Halbleiter-Schaltelements (1) das Addieren des Anstiegssignals zum Messsignal zumindest dann unterdrückt wird, wenn das Anstiegssignal größer als Null ist.

9. Schutzschaltung für ein steuerbares, nicht einrastendes Halbleiter-Schaltelement (1) mit zwei Schaltanschlüssen (2, 3) und einem Steueranschluss (4),
- wobei eine zwischen den Schaltanschlüssen (2, 3) liegende Verbindungsstrecke (1') durch Ansteuern des Steueranschlusses (4) niederohmig bzw. hochohmig steuerbar ist,
- wobei mit den Schaltanschlüssen (2, 3) eine Spannungsanstiegserkennuhgsschaltung (7) verbunden ist, mittels derer eine Geschwindigkeit erfassbar ist, mit der eine über den Schaltanschlüssen (2, 3) abfallende Schaltelementspannung (Uₛ) sich ändert,
- wobei mit den Schaltanschlüssen (2, 3) auch eine Spannungserkennungsschaltung (14) verbunden ist, mittels derer die Schaltelementspannung (Uₛ) erfassbar ist,
- wobei die Spannungsanstiegserkennungsschaltung (7) und die Spannungserkennungsschaltung (14) mit einem Additionspunkt verbunden sind, von dem ein zur Geschwindigkeit proportionales Anstiegssignal und ein zur Schaltelementspannung (Uₛ) proportionales Messsignal zu einem Summensignal addiert werden,
- wobei der Additionspunkt mit einem Trennsignalgeber (10) zum Ausgeben eines Trennsignals bei Überschreiten eines Grenzwerts durch das ihm zugeführte Summensignal verbunden ist,
- wobei der Trennsignalgeber (10) mit dem Steueranschluss (4) verbunden ist.

10. Schutzschaltung nach Anspruch 9,
**dadurch gekennzeichnet,**
**dass** dem Trennsignalgeber (10) ein Glättungselement (11) vorgeordnet ist.

11. Schutzschaltung nach Anspruch 9 oder 10,
**dadurch gekennzeichnet,**
**dass** der Spannungsanstiegserkennungsschaltung (7) ein Anstiegsverstärker (12) nachgeordnet ist.

12. Schutzschaltung nach Anspruch 11,
**dadurch gekennzeichnet,**
**dass** dem Anstiegsverstärker (12) ein Vorzeichenerkenner (13) für den Anstieg zugeordnet ist und dass der Vorzeichenerkenner (13) zur Vorgabe eines vorzeichenspezifischen Anstiegsverstärkungsfaktors (k+, k-) mit dem Anstiegsverstärker (12) verbunden ist.

13. Schutzschaltung nach Anspruch 11 oder 12,
**dadurch gekennzeichnet,**
**dass** die Spannungserkennungsschaltung (14) vor dem Anstiegsverstärker mit dem Additionspunkt verbunden ist.

14. Schutzschaltung nach Anspruch 11 oder 12,
**dadurch gekennzeichnet,**
**dass** die Spannungserkennungsschaltung (14) hinter dem Anstiegsverstärker (12) mit dem Additionspunkt verbunden ist.

15. Schutzschaltung nach einem der Ansprüche 9 bis 14,
**dadurch gekennzeichnet,**
**dass** zwischen der Spannungserkennungsschaltung (14) und dem Additionspunkt ein Spannungsverstärker (15) angeordnet ist.

16. Schutzschaltung nach einem der Ansprüche 9 bis 15,
**dadurch gekennzeichnet,**
**dass** zwischen der Spannungsanstiegserkennungsschaltung (7) und dem Trennsignalgeber (10) ein Schalter (16) angeordnet ist, der mit einem Ansteuerelement (5) für den Steueranschluss (4) verbunden ist, so dass der Schalter (16) bei Ausgeben eines Verbindungssignals für eine Ausblendzeit (T) öffenbar ist.

17. Schutzschaltung nach Anspruch 16,
**dadurch gekennzeichnet,**
**dass** dem Schalter (16) eine Diode (18) parallel gegengeschaltet ist.

## Claims

1. Method for protecting a controllable, non-locking semiconductor switching element (1) having two switching terminals (2, 3) and a control terminal (4),
- wherein a rate of change of a switching element voltage (U_{S}) dropped across the switching terminals (2, 3) is detected,
- wherein the switching element voltage (U_{S}) is also measured,
- wherein a rise signal proportional to the rate of change and a measurement signal proportional to the switching element voltage (U_{S}) are added together to produce a sum signal,
- wherein a link section (1') between the switching terminals (2, 3) is set to high impedance by applying drive to the control terminal (4) if the sum signal exceeds a voltage limit value.

2. Protection method according to claim 1,
**characterised in that** the sum signal is smoothed.

3. Protection method according to claim 1 or 2,
**characterised in that** the rise signal is weighted with a rise amplification factor (k+, k-).

4. Protection method according to claim 3,
**characterised in that** the rise signal is weighted on a sign-specific basis.

5. Protection method according to claim 3 or 4,
**characterised in that** the rise signal and the measurement signal are added prior to amplification of the rise signal.

6. Protection method according to claim 3 or 4,
**characterised in that** the rise signal and the measurement signal are added after amplification of the rise signal.

7. Protection method according to one of the above claims,
**characterised in that** the measurement signal is weighted with a voltage gain factor (k) prior to addition.

8. Protection method according to one of the above claims,
**characterised in that** during a blanking period (T) after activation of the semiconductor switching element (1), the addition of the rise signal to the measurement signal is suppressed at least when the rise signal is greater than zero.

9. Protection circuit for a controllable, non-locking semiconductor switching element (1) having two switching terminals (2, 3) and a control terminal (4),
- wherein a link section (1') between the switching terminals (2, 3) can be set to low or high impedance by applying drive to the control terminal (4),
- wherein there is connected to the switching terminals (2, 3) a voltage rise detection circuit (7) by means of which a rate of change of a switching element voltage (U_{S}) dropped across the switching terminals (2, 3) can be detected,
- wherein there is also connected to the switching terminals (2, 3) a voltage detection circuit (14) by means of which the switching element voltage (U_{S}) can be measured,
- wherein the voltage rise detection circuit (7) and the voltage detection circuit (14) are connected to an addition point by which a rise signal proportional to the rate of change and a measurement signal proportional to the switching element voltage (U_{S}) are added together to produce a sum signal,
- wherein the addition point is connected to a disconnect signal generator (10) for outputting a disconnect signal if a limit value is exceeded by the sum signal applied thereto,
- wherein the disconnect signal generator (10) is connected to the control terminal (4).

10. Protection circuit according to claim 9,
**characterised in that** the disconnect signal generator (10) is preceded by a smoothing element (11).

11. Protection circuit according to claim 9 or 10,
**characterised in that** the voltage rise detection circuit (7) is followed by a rise amplifier (12).

12. Protection circuit according to claim 11,
**characterised in that** the rise amplifier (12) is assigned a sign detector (13) for the rise and that the sign detector (13) is connected to the rise amplifier (12) to predefine a sign-specific rise amplification factor (k+, k-).

13. Protection circuit according to claim 11 or 12,
**characterised in that** the voltage detection circuit (14) is connected to the addition point upstream of the rise amplifier.

14. Protection circuit according to claim 11 or 12,
**characterised in that** the voltage detection circuit (14) is connected to the addition point downstream of the rise amplifier (12).

15. Protection circuit according to one of claims 9 to 14,
**characterised in that** a voltage amplifier (15) is disposed between the voltage detection circuit (14) and the addition point.

16. Protection circuit according to one of claims 9 to 15,
**characterised in that** there is disposed between the voltage rise detection circuit (7) and the disconnect signal generator (10) a switch (16) which is connected to a drive element (5) for the control terminal (4) such that said switch (16) can be opened for a blanking period (T) during outputting of a connect signal.

17. Protection circuit according to claim 16,
**characterised in that** a diode (18) is connected in parallel back-to-back with the switch (16).

## Revendications

1. Procédé de protection d'un élément ( 1 ) de commutation à semi-conducteur pouvant être commandé, sans verrouillage, et qui comprend deux bornes ( 2, 3 ) de commutation et une borne ( 4 ) de commande,
- dans lequel on détecte une vitesse, à laquelle une tension ( U_{S}) de l'élément de commutation chutant aux bornes (2, 3 ) de commutation se modifie,
- dans lequel on détecte aussi la tension ( U_{S} ) de l'élément de commutation,
- dans lequel on ajoute, en un signal somme, un signal de montée proportionnel à la vitesse et un signal de mesure proportionnel à la tension ( U_{S} ) de l'élément de commutation,
- dans lequel on commande, à grande valeur ohmique, une section ( 1' ) de liaison se trouvant entre les bornes ( 2,3 ) de commutation, en commandant la borne ( 4 ) de commande, lorsque le signal somme dépasse une valeur limite de tension.

2. Procédé de fabrication suivant la revendication 1,
**caractérisé**
**en ce que** l'on lisse le signal somme.

3. Procédé de fabrication suivant la revendication 1 ou 2,
**caractérisé**
**en ce que** l'on pondère le signal de montée par un facteur ( k+, k- ) d'amplification de montée.

4. Procédé de fabrication suivant la revendication 3,
**caractérisé**
**en ce qu'**on effectue la pondération du signal de montée d'une manière spécifique en signe.

5. Procédé de fabrication suivant la revendication 3 ou 4,
**caractérisé**
**en ce que** l'on ajoute le signal de montée et le signal de mesure avant l'amplification du signal de montée.

6. Procédé de fabrication suivant la revendication 3 ou 4,
**caractérisé**
**en ce que** l'on ajoute le signal de montée et le signal de mesure après l'amplification du signal de montée.

7. Procédé de fabrication suivant l'une des revendications précédentes,
**caractérisé**
**en ce que** l'on pondère le signal de mesure par un facteur ( k ) d'amplification de tension avant l'addition.

8. Procédé de fabrication suivant l'une des revendications précédentes,
**caractérisé**
**en ce que** pendant un temps ( T ) de suppression, après mise à l'état passant de l'élément ( 1 ) de commutation à semi-conducteur, on supprime l'addition du signal de montée au signal de mesure, au moins lorsque le signal de montée est supérieur à 0.

9. Circuit de protection pour un élément ( 1 ) de commutation à semi-conducteur pouvant être commandé, sans verrouillage, ayant deux bornes ( 2, 3 ) de commutation et une borne ( 4 ) de commande,
- dans lequel une section ( 1' ) de liaison se trouvant entre les bornes ( 2, 3 ) de commutation peut être commandée à petite valeur ohmique ou à grande valeur ohmique en commandant la borne ( 4 ) de commande,
- dans lequel aux bornes ( 2, 3 ) de commutation est relié un circuit ( 7 ) de détection de montée de la tension, au moyen duquel peut être détecté une vitesse à laquelle une tension ( Uₛ ) de l'élément de commutation chutant aux bornes ( 2, 3 ) de commutation se modifie,
- dans lequel aux bornes ( 2, 3 ) de commutation est relié aussi un circuit ( 14 ) de détection de tension, au moyen duquel la tension ( U_{S} ) de l'élément de commutation peut être détectée,
- dans lequel le circuit ( 7 ) de détection de montée de la tension et le circuit ( 14 ) de détection de la tension sont reliés à un point d'addition, par lequel un signal de montée proportionnel à la vitesse et un signal de mesure proportionnel à la tension ( U_{S} ) de l'élément de commutation sont additionnés en un signal somme,
- dans lequel le point d'addition est relié à un générateur ( 10 ) de signal de séparation pour émettre un signal de séparation, lorsque qu'une valeur limite est dépassée par le signal somme qui lui est envoyé,
- dans lequel le générateur ( 10 ) de signal de séparation est relié à la borne ( 4 ) de commande.

10. Circuit de protection suivant la revendication 9,
**caractérisé**
**en ce qu'**un élément ( 11 ) de lissage est monté en amont du générateur ( 10 ) de signal de séparation.

11. Circuit de protection suivant la revendication 9 ou 10,
**caractérisé**
**en ce qu'**un amplificateur ( 12 ) de montée est monté en aval du circuit ( 7 ) de détection de montée de la tension.

12. Circuit de protection suivant la revendication 11,
**caractérisé**
**en ce qu'**un détecteur ( 13 ) de signe pour la montée est associé à l'amplificateur ( 12 ) de montée et en ce que le détecteur ( 13 ) de signe est, pour la prescription d'un facteur ( k+,k- ) d'amplification de montée et spécifique en signe, relié à l'amplificateur ( 12 ) de montée.

13. Circuit de protection suivant la revendication 11 ou 12,
**caractérisé**
**en ce que** le circuit ( 14 ) de détection de la tension est relié au point d'addition en amont de l'amplificateur de montée.

14. Circuit de protection suivant la revendication 11 ou 12,
**caractérisé**
**en ce que** le circuit ( 14 ) de détection de la tension est relié au point d'addition en aval de l'amplificateur ( 12 ) de montée.

15. Circuit de protection suivant l'une des revendications 9 à 14,
**caractérisé**
**en ce qu'**un amplificateur ( 15 ) de tension est monté entre le circuit ( 14 ) de détection de la tension et le point d'addition.

16. Circuit de protection suivant l'une des revendications 9 à 15,
**caractérisé**
**en ce qu'**entre le circuit ( 7 ) de détection de montée de la tension et le générateur ( 10 ) de signal de séparation est monté un interrupteur ( 16 ) qui est relié à un élément ( 5 ) de commande de la borne ( 4 ) de commande, de manière à ce que l'interrupteur ( 16 ) puisse être ouvert lors de l'émission d'un signal de liaison pendant un temps ( T ) d'extraction.

17. Circuit de protection suivant la revendication 16,
**caractérisé**
**en ce qu'**une diode ( 18 ) est montée en opposition à l'interrupteur ( 16 ).
